# EUROPEAN PATENT SPECIFICATION

(11) **EP 0 321 552 B1**
(45) Date of publication and mention of the grant of the patent: **30.08.1995**
(21) Application number: 88906413.5
(22) Date of filing: 20.06.1988
(51) Int. Cl.: G06F 1/04, G06F 7/04, H03K 19/003

(54) **AUTOMATIC CLOCK DE-SKEWING ON A CIRCUIT BOARD**
AUTOMATISCHE TAKTZEIT-BEGRADIGUNG IN EINER BAUGRUPPE
CORRECTION AUTOMATIQUE DE DESALIGNEMENT D'HORLOGE SUR UNE CARTE DE CIRCUITS

(30) Priority: 30.06.1987 US 68284; 30.06.1987 US 68285
(43) Date of publication of application: 28.06.1989
(73) Proprietor: UNISYS CORPORATION, Blue Bell, PA 19424-0001 (US)
(72) Inventor: FLORA, Laurence, Paul, Covina, CA 91724 (US); McCULLOUGH, Michael, Anthony, Pasadena, CA 91107 (US)
(74) Representative: Eisenführ, Speiser & Partner
(86) International application number: US8802060
(87) International publication number: WO8900311

(56) References cited:
- EP-A-01 735 21
- US-A- 4 047 132
- IBM TECHNICAL DISCLOSURE BULLETIN, VOL. 24, NO. 2, JULY 1981 (NEW YORK, US), A. BLUM: "AUTOMATIC ADJUSTMENT OF SEVERAL DECENTRALLY GENERATED CLOCK PULSE SEQUENCES OF A COMPUTER DISTRIBUTED OVER SEVERAL VLSI CHIPS" PAGES 895-897

## Description

### BACKGROUND

This invention relates generally to data processing systems and more particularly to improved means and methods for overcoming the deleterious effects of propagation time variations in a synchronous digital data processing system.

A particular problem which is caused by propagation time variations in a synchronous data processing system occurs in connection with the design of a clock distribution system. For example, propagation time variations can produce significant skewing of the clocks applied to different parts of the system. In order to prevent this skewing from creating timing problems, a conventional solution is to add the maximum skew to the minimum system cycle time so as to thereby guarantee that all data signals arrive at their destination storage elements (e.g., flip-flops) before the clock does. In today's high performance systems (either computers or other systems designed using digital devices), this increase in cycle time can have a significant deleterious effect on system speed.

A primary cause of skew in a data processing system is a result of propagation time variations which occur between integrated circuit chips due to manufacturing process tolerances. This is a particularly sensitive problem in the case of clock distribution circuitry, since inter-chip propagation time delays will produce skews in the clocks distributed throughout the system.

One solution to the skew problem is to improve chip fabrication processes to make chips more uniform so that tolerances from chip-to-chip are smaller. However, the increased cost that would be involved makes this solution economically impractical.

Another type of solution which has been employed to minimize skew is to provide for manual (or operator-controlled) adjustment of the clock distribution system, such as disclosed for example in US-A-4,447,870. Besides the inconvenience of having to provide manual or operator-controlled adjustment, this solution is also expensive because of the increased labor and/or set-up which would be required. Furthermore, such initial skew adjustment cannot compensate for skew resulting from later occurring factors, such as temperature variations.

It is to be noted that clock skew can also present problems in connection with communication receiver circuitry where signals may be received at times which are not properly in phase with a system clock. Special synchronizing techniques have been developed for handling asynchronous received signals, such as disclosed, for example, in US-A-3,908,084. However, because of the different factors involved, such techniques are not appropriate for solving the inter-chip propagation time variation problem. EP-A-0 173 521 defining the closest prior art from which the invention proceeds discloses a method and apparatus for automatically adjusting the propagation time delay of an electrical circuit, such as an integrated circuit chip. These known method and apparatus are employed to de-skew the clock outputs provided by a plurality of clock distribution chips having different signal propagation times. A feedback circuitry including a multi-tapped delay line and an accurate constant delay are employed in conjunction with a phase comparator for automatically adjusting the propagation delay of each chip to provide substantially the same constant delay relative to a main system clock for the clock outputs provided by the clock distribution chips.

### SUMMARY OF THE INVENTION

In accordance with the invention, it is provided a method for automatically providing de-skewed clocks for a data processing system including a plurality of circuit boards, each board mounting data processing circuitry chips, said method comprising the steps of:
applying an input clock to each board;
on each board, distributing de-skewed output clocks to chips on the board by performing automatic clock de-skewing in response to said input clock using an accurate reference delay to determine the amount of de-skewing required,
wherein each circuit board is of multi-layer construction comprising conductive planes separated by insulating dielectric layers; and
providing said accurate reference delay for each circuit board by forming a transmission line along an edge portion of an inner conductive plane.

Advantageous embodiments of the method according to the invention are defined in the subclaims 2 to 10.

Furthermore, in accordance with the invention, it is provided a data processing system including a plurality of circuit boards, each board mounting data processing circuitry chips, and a clock distribution chip which is responsive to an input clock being input to the circuit board and which distributes de-skewed output clocks to the data processing circuitry chips on said circuit board, and which adjusts the relative delay between an output clock and said input clock to a predetermined constant value, said input clock being provided to an accurate reference delay means to determine the required amount of de-skewing, said accurate reference delay means comprising a transmission line, characterized in that
each circuit board is of a multi-layer construction comprising conductive planes separated by insulating dielectric layers, said transmission line being formed by an edge portion of an inner conductive plane, the ends of said transmission line being connected to the top of the circuit board for receiving respective ones of the terminals of the clock distribution chip.

Further advantageous embodiments of the system of the invention are defined in the subclaims 12 to 25.

### BRIEF DESCRIPTION OF THE DRAWINGS

FIG. 1 is an electrical block diagram generally illustrating how clocking is provided for a plurality of circuit boards of a data processing system in a preferred embodiment of the invention.

FIG. 2 is an electrical block diagram illustrating a preferred implementation of a clock distribution chip 5a in FIG. 1 in accordance with the preferred embodiment of the invention.

FIGS. 3A and 3B comprise timing groups illustrating the overall operation of the clock distribution chip 5a of FIG. 2.

FIG. 4 is an electrical block diagram illustrating a more specific implementation of the clock distribution chip 5a illustrated in FIG. 2.

FIG. 5 comprises timing graphs illustrating operation of the implementation of FIG. 4 for a specific example of automatic clock delay adjustment in accordance with the preferred emodiment of the invention.

FIG. 6 is an electrical block diagram illustrating how error checking may additionally be provided for the implementation of FIG. 4.

FIG. 7 comprises timing graphs illustrating the operation of FIG. 6.

FIG. 8 is a diagrammatic cross-sectional representation of a multi-layer board construction which may be employed in the described embodiment.

FIG. 9 is a plane view of a conductive plane of the multi-layer board construction illustrated in FIG. 8 illustrating how a precise delay line can be provided therein.

### DETAILED DESCRIPTION OF THE INVENTION

Like numerals and characters designate like elements throughout the drawings.

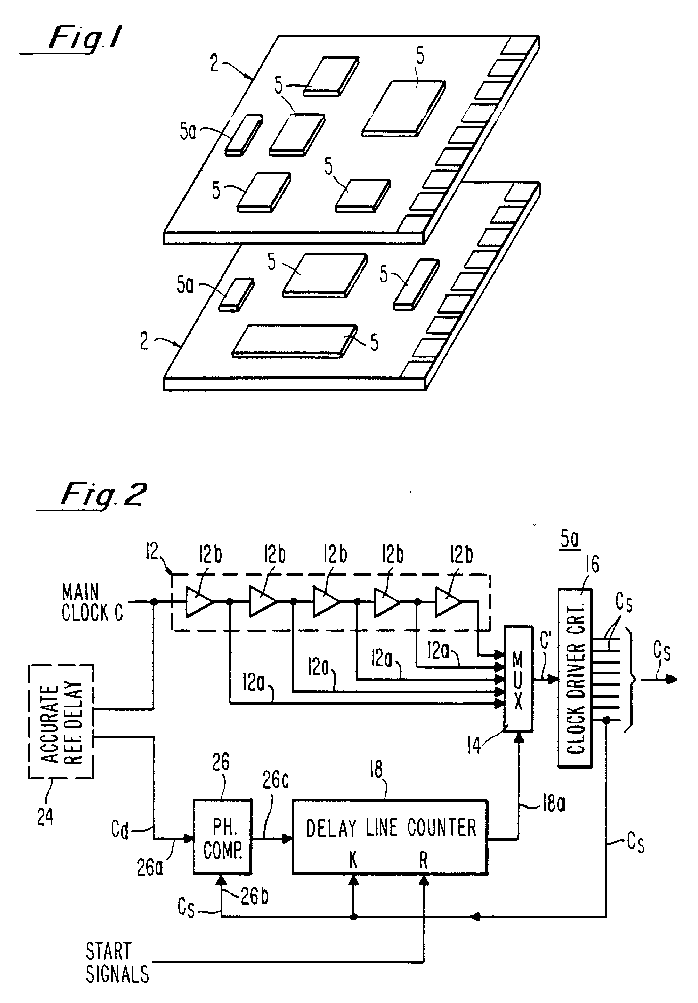

Referring initially to FIG. 1, illustrated therein is a plurality of circuit boards 2 of a data processing system. Each circuit board 2 has a plurality of integrated circuit chips 5 and 5a mounted thereto and interconnected by electrical connections (not shown) in a conventional manner. The boards 2 are in turn interconnected in a conventional manner using other boards, backplanes or the like (also not shown).

The chip 5a on each board 2 is a clock distribution chip to which an input clock is applied, each input clock being derived from a main clock C. This clock distribution chip 5a is constructed and arranged to operate in response to the applied main clock C so as to provide output clocks which are distributed to appropriate ones of the other chips 5 on the board for providing clocking therefor.

In order to prevent clock skew, it is conventional to choose conductor lengths so that the resulting main clocks C applied to the clock distribution chips of the boards 2 are substantially in phase with one another. Also to prevent clock skew, it is conventional to provide for equal conductor lengths between the clock outputs of the clock distribution chip 5a and the clock inputs of the other chips 5 on the board so that the resulting clocks applied to each chip on the same board will be substantially in phase with one another. While these measures help to reduce clock skew, differences in the propagation times provided by the distribution chips 5a also have to be taken into account, since such differences can produce skew with respect to the outputs of different boards. A preferred manner for solving this problem is by the provision of automatic clock deskewing circuitry on each board 2 which will bring the outputs of all of the clock distribution chips 5a substantially into phase with one another despite propagation delay variations which typically occur in the clock driver circuits. A preferred manner for achieving this advantageous result is to incorporate automatic clock de-skewing circuitry on each clock distribution chip 5a.

FIG. 2 illustrates a particular preferred implementation of a clock distribution chip 5a in FIG. 1 incorporating circuitry for automatically adjusting the delay between an output clock Cₛ and the applied main system clock C to a desired constant value. It is to be understood that all of the chips 5a shown in FIG. 1 are preferably implemented in a like manner.

The preferred implementation of the clock distribution chip 5a shown in FIG. 2 will now be considered in more detail. As shown, a main clock C is applied to a multi-tapped delay line 12 which provides a plurality of outputs 12a having successively larger delays relative to the main clock C depending upon their location along the multi-tapped delay line 12. As shown, the multi-tapped delay line 12 may, for example, comprise a string of gates 12b.

The delay line outputs 12a in FIG. 2 are applied to a multiplexor 14 which selects a particular one of the outputs 12a as determined by a count output 18a applied thereto from a delay line counter 18. The resulting selected clock C′ appearing at the output of the multiplexor 14 is applied to conventional clock driver circuitry 16 for producing the output clock signals Cₛ to be distributed to other chips 5 on the same board (FIG. 1).

It will be seen in FIG. 2 that, besides being applied to the multi-tapped delay line 12, the main clock C is also applied to an accurate fixed reference delay means 24 (indicated by the dashed elongated block in FIG. 2) which produces a delayed clock signal C_{d} having a delay d₀ relative to the main clock C. In accordance with the present invention, this accurate fixed delay 24 is provided off-chip by a specially formed conductor provided in each board, the construction and arrangement of which will be more specifically considered later on herein.

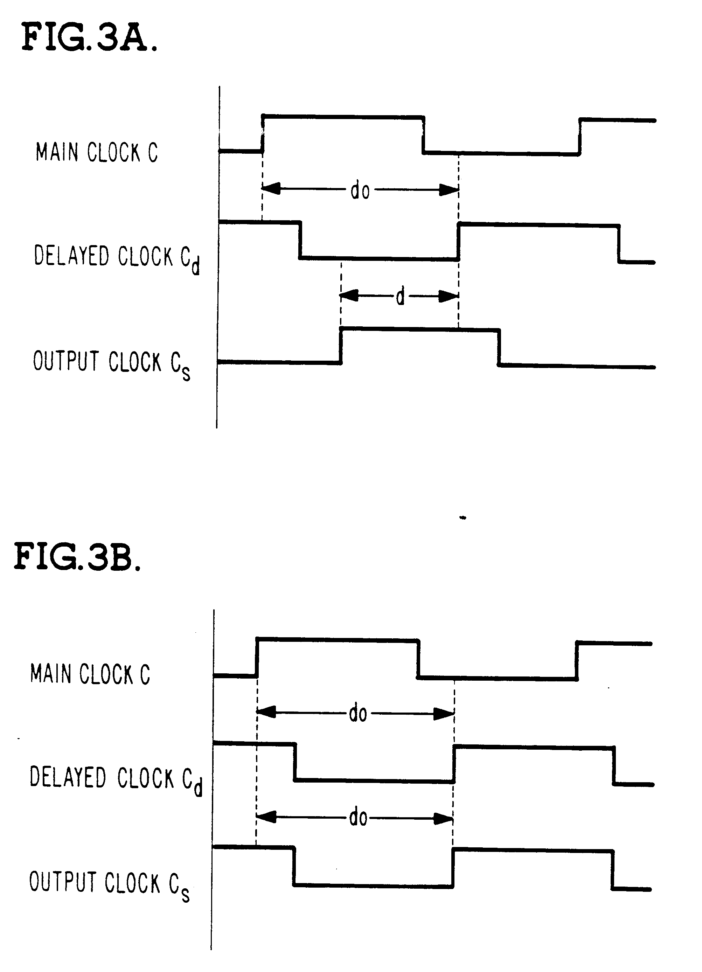

The resulting delayed clock signal C_{d} provided by the reference delay 24 is applied to one input 26a of a phase comparator 26 while a representative output clock signal Cₛ from the clock driver circuitry 16 is fed back to the other phase comparator input 26b. Basically, operation of the preferred clock distribution chip 5a in FIG. 2 is caused to be such that, each time the phase comparator 26 detects that the clock signals C_{d} and Cₛ have different delays relative to the main clock C (as illustrated for example by d in FIG. 3A), a count signal is caused to be produced at the phase comparator output 26c. This count signal causes the counter 18 to count (from an initial count set by a start signal S applied to the counter reset input R) until the count output 18a reaches a count such that the output 12a selected by the multiplexor 14 produces an output clock signal Cₛ having substantially the same delay d₀ relative to the main clock C as the delayed clock C_{d} (as illustrated for example in FIG. 3B), at which time the count signal is removed so that the then existing delay d₀ provided for Cₛ relative to the main clock C remains constant.

Thus, the circuit of FIG. 2 will have automatically been adjusted to provide output clock signal Cₛ having an accurate delay relative to the main clock C, as determined by the accurate reference delay means 24. Since all of the clock distribution chips 5a in FIG. 1 can be designed in a like manner, the clock signals Cₛ from all of the chips 5a of the clock distribution system can automatically be provided with substantially the same delay relative to the main clock C in this advantageous manner, which may be accomplished for example during power-on initialization.

A particular advantage of the preferred embodiment illustrated in FIG. 2 is that the provision of the accurate reference delay means 24 permits the string of gates 12b used for the multi-tapped delay line 12 to be simply and economically implemented. Although the timing accuracy obtained using such a string of gates 12b is poor, there is no deleterious effect on circuit performance, since inaccuracies will automatically be tuned out by the feedback action which relies on the reference delay means 24 for timing accuracy.

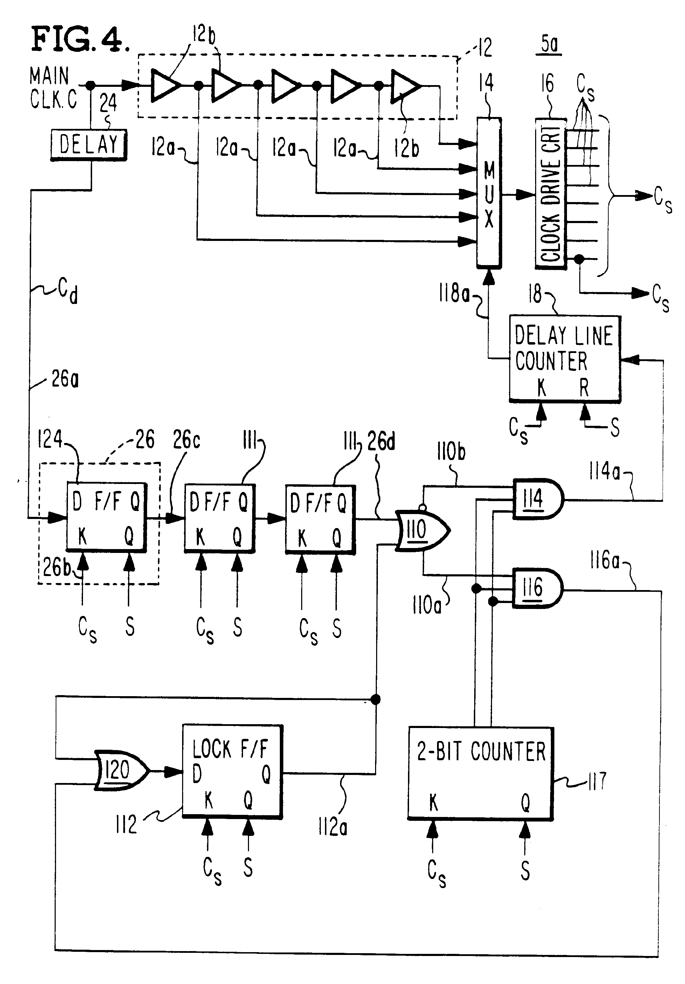

Referring next to FIG. 4, illustrated therein is a more specific preferred embodiment of a chip 5a in FIG. 1. Components which perform functions similar to those which have already been considered in connection with FIG. 2 have been given the same designations. Also, components in FIG. 4 which are not specifically shown in FIG. 2 have been given numbers greater than 100.

As in FIG. 2, the main clock C in FIG. 4 is applied to the multi-tapped delay line 12 whose outputs 12a are in turn applied to the multiplexor 14 which operates in response to the count output 18a provided by the counter 18 to select a particular one of these outputs 12a for application to the clock driver circuitry 14 for producing the output clock signals Cₛ.

Also as in FIG. 2, the main clock C in FIG. 4 is applied, via the accurate reference delay means 24, to the phase comparator input 26a, while a representative output clock signal Cₛ from the clock driver circuitry 16 is applied to the other phase comparator input 26b. FIG. 4 shows that this phase comparator 26 may typically comprise a flip-flop 124 wherein the flip-flop input D serves as the phase comparator input 26a to which the delayed clock signal C_{d} is applied, wherein the flip-flop clock input K serves as the phase comparator input 26b to which the output clock signal Cₛ is applied, and wherein the flip-flop output Q serves as the phase comparator output 26c. As will be noted in FIG. 4, the clock signal Cₛ is used as the clock applied to the clock inputs K of the clocked components (such as counter 18 and flip-flop 124) while the start signal S (provided for example during power-up initialization) is applied to the reset inputs R of these components for resetting them to desired initial states.

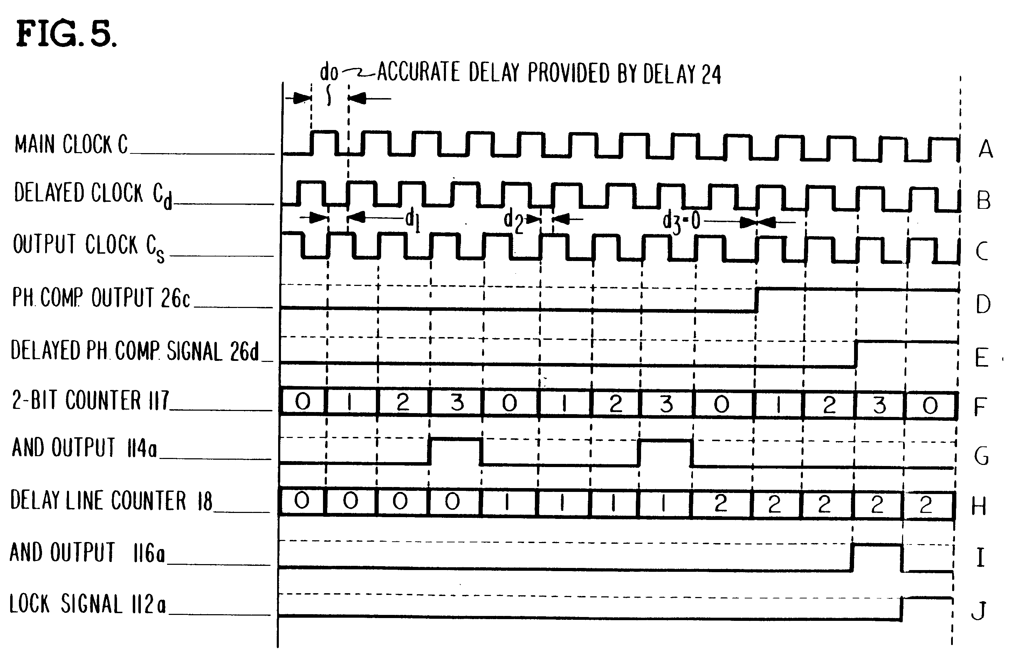

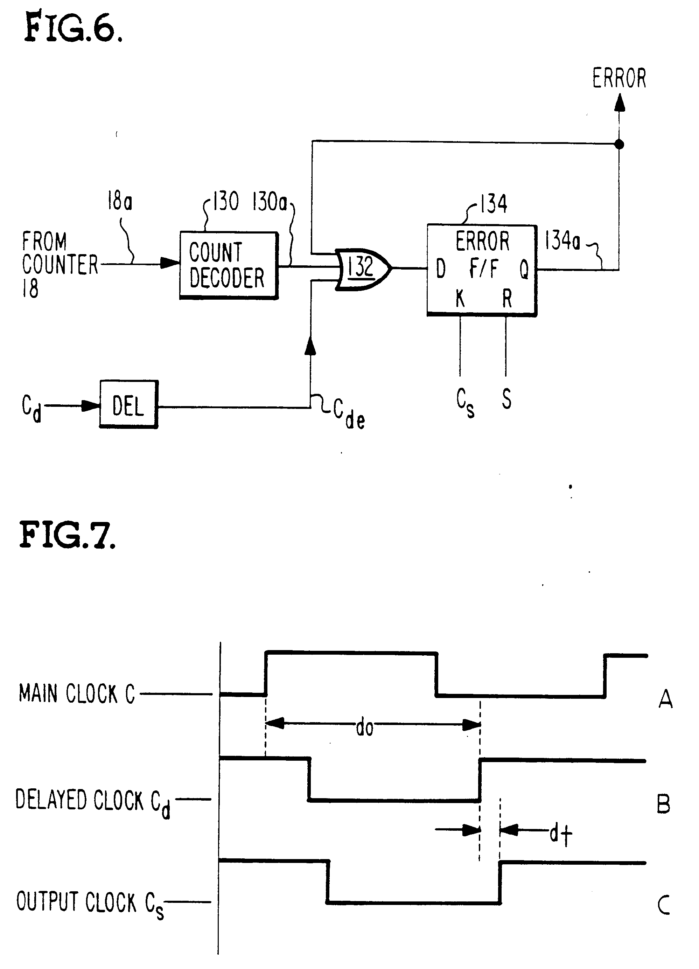

FIG. 5 illustrates typical graphs for the main clock C, the delayed clock C_{d}, the output clock C, the phase comparator output 26c and other pertinent outputs in the embodiment of FIG. 4 during a typical example of automatic clock delay adjustment. For greater clarity, the waveforms shown in FIG. 5 as well as those shown in FIGS. 3A, 3B and 7 are illustrated in idealized form.

As illustrated in FIG. 4, the phase comparator output 26c (Graph D in FIG. 5) is applied to an OR gate 110 via a string of two flip-flops 111 which provide a two-clock delayed phase comparator signal 26d (Graph E). The use of this string of flip-flops 111 is advantageous in that it reduces meta-stability problems in the logic following thereafter. If at the rise of the clock Cₛ (Graph C) the delayed clock C_{d} (Graph B) is low because the delay of Cₛ relative to the main clock C does not equal that of C_{d} as indicated by d₁ in Graph C (see also FIG. 3A), then the phase comparator output 26c (Graph D) will also be low. Since this phase comparator output signal 26c is applied to the string comprised of the two flip-flops 111, the delayed phase comparator output signal 26d (Graph E) will correspond to that of the phase comparator output signal 26c two clock periods earlier.

As shown in FIG. 4, the delayed phase comparator output signal 26d (Graph E) is applied to an input of an OR gate 110, while a lock flip-flop 112 applies a lock signal 112a (which is initially set to a low value) to another input of the OR gate 110. The OR gate 110 has two outputs, an OR output 110a and an inverse OR output 110b. Thus, when the phase comparator output signal 26c (Graph D) is low, the OR output 110a will be low while the inverse OR output 110b will be high, and vice versa, when the phase comparator output signal 26c is high.

Still with reference to FIG. 4, the inverse OR output 110b is applied to an input of an AND gate 114 while the OR output 110a is applied to an input of an AND gate 116. Applied to two other inputs of each of the AND gates 114 and 116 are the outputs 117a and 117b of a 2-bit counter 117 whose four counts (0, 1, 2 and 3) are illustrated in Graph F of FIG. 5. It will be understood that the logic performed by OR gate 110 and AND gates 114 and 116 in conjunction with the 2-bit counter 117 is such that, each time the count of the 2-bit counter 117 reaches 3, the AND gates 114 and 116 will be enabled since at the count of 3 both counter outputs 117a and 117b will be high. Thus, each time the AND gates 114 and 116 are enabled (as a result of the counter 117 reaching the count of 3), the AND gate output 114a (Graph G) will correspond to the state of the inverse OR output 110b, which in turn corresponds to the inverse of the current state of the delayed phase comparator output signal 26d (Graph E), while the AND gate output 116a (Graph H) will correspond to the current state of the OR output 110a, which in turn corresponds to the state of the lock signal 112a.

As will be understood from the example illustrated in FIG. 5, when the 2-bit counter 117 (Graph F) first reaches a count of 3 (causing AND gates 114 and 116 to be enabled), the delayed phase comparator output 26d (Graph E) will be low since the delay of the output clock Cₛ (Graph C) is less than that of the delayed clock C_{d} (as indicated by the delay difference d₁ in Graph C). As a result, the resulting high level appearing at the inverse OR output 110b will cause the AND output 114a (Graph G) to become high during count 3 of the two-bit counter 117 (Graph F), which in turn will cause the delay line counter 18 (Graph H) to advance from its initial count 0 to count 1, causing the multiplexor 14 to select the next greater delay line tap 12a. This increases the delay of Cₛ such that a reduced delay difference d₂ (Graph C) is obtained between Cₛ and C_{d}. Since the OR output 110a will be low during count 3 of the 2-bit counter 117, the AND gate output 116a (Graph I) will also be false so that, when applied via an OR gate 120 to the data input D of the lock flip-flop 112, the lock flip-flop output 112a (Graph I in FIG. 5) will remain low.

When the two-bit counter 117 (Graph F in FIG. 5) reaches count 3 for the second time, the delayed phase comparator output (Graph E) will still be low because of the remaining delay difference d₂ (Graph C) between Cₛ and C_{d}. Thus, as described for the previous arrival of the 2-bit counter 117 at count 3 (Graph F), the AND output 114a will again become high to now advance the delay line counter 18 (Graph H) to count 2 while the lock flip-flop output 112a again remains low.

For the particular example illustrated in FIG. 5, it is assumed that the advance of the delay line counter 18 to its second count causes the delay of Cₛ to be increased so that the delay of Cₛ relative to the main clock C (Graph A) is substantially equal to the delay of C_{d} relative to C, as indicated by the d₃ = 0 designation in Graph C of FIG. 5. As a result of having achieved this match between Cₛ and C_{d}, the phase comparator output 26a now becomes high, as shown in Graph D of FIG. 5, which in turn causes the delayed phase comparator output 26d (Graph E) to become high two clock periods later, which period corresponds to the third arrival of the 2-bit counter 117 at count 3 (Graph F). Thus, during this third occurrence of count 3 of the two-bit counter 117, the AND output 114a (Graph G) will now be low while the AND output 116a (Graph H) will become high (Graph I) and pass via OR gate 120 to the input of the lock flip-flop 112 so as to also set the lock signal 112a high as shown in Graph J.

It will be understood that when the lock signal 112a becomes high as just described, it will be locked in this high setting because the lock signal 112a is fed back via OR gate 120 to the data input of the lock flip-flop 112. It will also be understood that since the lock signal 112a is also applied to OR gate 110, this locked in high level of the lock signal 112a will thereafter cause a low level output to be applied to AND gate 114 to prevent its being enabled. Thus, any further advancement of the delay line counter 18 is prevented, thereby locking in the desired matched relationship between C_{d} and Cₛ. It will be noted in this regard that the 2-bit counter 117 is advantageous in that it provides for alternating between detecting the phase difference between C_{d} and Cₛ and advancing the counter 18, thereby facilitating the locking in of the desired matched relationship between Cₛ and C_{d}.

FIG. 6 illustrates how error checking may additionally be provided for the implementation of FIG. 4. Two types of error checking are illustrated in FIG. 6. First, a counter decoder 130 is provided to which the count of the delay line counter 18 in FIG. 2 is applied. The decoder 130 is constructed and arranged in a conventional manner to provide a high output signal 130a via an OR gate 132 to the data input D of an error flip-flop 134. If the count of the delay line counter 18 advances beyond a predetermined maximum count (indicating that the delay required to be added to Cₛ in order to match C_{d} is greater than can be provided by the delay line 12), the decoder output 130a becomes high to set the error flip-flop 134 so as to thereby set the error flip-flop output 134a high, indicating an error.

A second type of error checking illustrated in FIG. 6 is provided by applying the delayed clock signal C_{d} to the error flip-flop 134 (via the OR gate 132) to an error check delay circuit 136 which produces an additionally delayed clock signal C_{de}. Graphs A, B and C in FIG. 7 illustrate typical waveforms for C, C_{d} and C_{de}, respectively. It will be understood that if, as illustrated by d+ in FIG. 7, the delay of Cₛ relative to the main clock C is greater than C_{de} (in which case no proper match can be obtained between Cₛ and C_{d}), then the error flip-flop 134 will be set (since both Cₛ and C_{de} will be high) to set the error flip-flop output 134a high to indicate an error. Once set, the error flip-flop 134 remains set since the error flip-flop output 134a is fed back via OR gate 132 to the data input D of the error flip-flop 134.

As was pointed out previously, the accurate reference delay (FIGS. 2 and 4) is an important element of the automatic clock de-skewing circuitry provided on the clock distribution chip 5a. In a typical state of the art data processing system, the reference delay means 24 might be required to provide an accurate delay of, for example, six nanoseconds. Such a delay with the required accuracy would be most difficult and expensive to provide either on a chip or as a lumped delay. In accordance with the present invention, this accurate reference delay means 24 is advantageously provided as a strip line conductor formed from an edge of an inner plane of a conventional type of multi-layer circuit board employed for each of the boards 2 (FIG. 1).

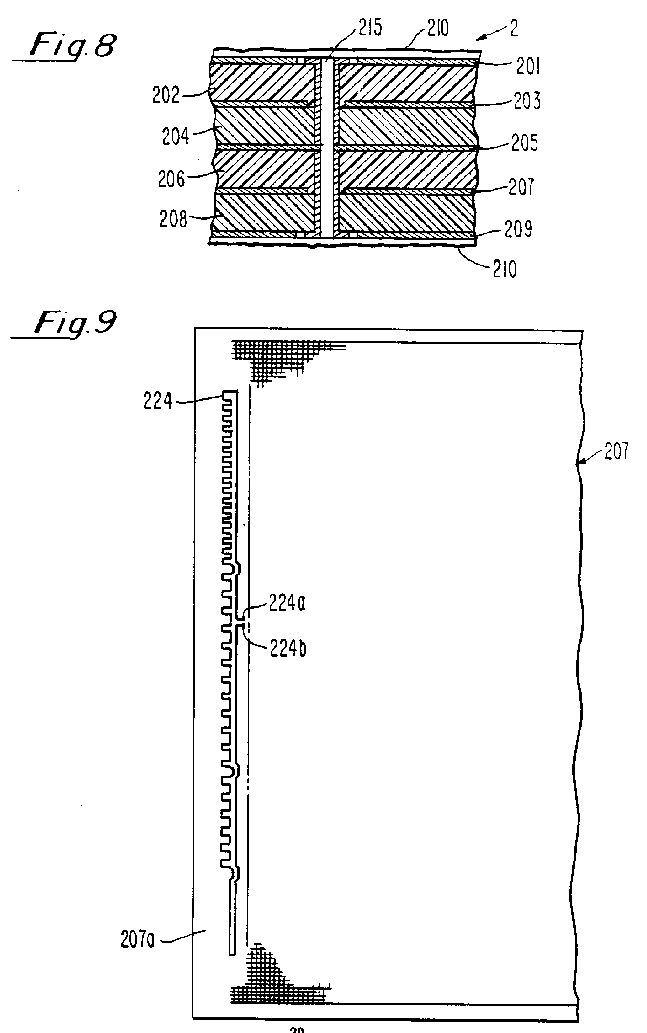

A multi-layer board construction which may be employed for each board 2 in FIG. 1 is schematically illustrated in FIG. 8. As shown in FIG. 8, this board comprises conductive planes 201, 203, 205, 207 and 209 separated by insulating dielectric layers 202, 204, 206 and 208 with multiwire magnet wiring 210 being provided adjacent the top and bottom conductive planes 201 and 207. Typically, integrated circuit chips (such as illustrated by 5 and 5a in FIG. 1) are mounted adjacent the top plane 201. Conductive planes 201, 205 and 209 may, for example, serve as ground planes and conductive planes 203 and 207 may serve as voltage planes. Also, plated-through holes, such as indicated at 215, are provided in a conventional manner passing through the board structure for making desired connections between the conductive planes and the magnet wiring 210 and integrated circuit chips. As is also conventional, flow soldering techniques may be used adjacent surface 209 to electrically connect the plated-through holes 215 in a desired pattern. Various types of multi-layer circuit board constructions which may also be employed in accordance with the invention will be evident from US-A-4,047,132 and 4,560,962 and the references identified therein.

Reference is now directed to FIG. 9 which illustrates how the reference delay 24 (FIGS. 2 and 4) may be provided as a predetermined length conductive strip 224 serving as a transmission line and formed from an edge portion of conductive plane 207 of the multi-layer board structure illustrated in FIG. 8. Other ones of the conductive planes could also be employed. An internal conductive plane is preferred since it facilitates maintaining a desired impedance, and also because the propagation delay provided thereby is primarily determined by the length of the strip 224.

In a particular preferred embodiment, a length of 66,04 - 76,20 cm (26 to 30 inches) is chosen for the strip 224, which provides a delay of about 6 nanoseconds. The cross-sectional thickness is typically 0,0762 mm (3 mils) and the strip width is typically 0,2032-0,254 mm (8-10 mils). The particular path followed by the strip 224 is chosen to provide the desired length, and also so as to pass around any holes which may be provided for other purposes in the multi-layer board structure. The ends of the strip 224 are formed as pads 224a and 224b. These pads 224 and 224b are connected to plated-through holes that extend to the top of the board and receive respective ones of the terminals of the clock distribution chip 5a (FIG. 1) so as to provide the electrical connections between the automatic de-skewing circuitry and the reference delay means 24 illustrated in FIGS. 2 and 4. It will be understood that, since the length of the strip 224 can be very accurately controlled with known strip forming techniques, a very accurate propagation delay can be provided for the automatic de-skewing circuitry.

The strip 224 shown in FIG. 9 may be formed by selectively etching the edge portion 207a of the plane 207 such that only the conductive strip 224 remains, as shown. Preferably, the clock distribution chip 5a (FIG. 1) is mounted above this edge portion 207a so that electrical connections can readily be provided between the strip pads 224a and 224b and their respective terminals of the clock distribution chip 5a using plated-through holes. The remaining portion of plane 207 shown in FIG. 9 is conventional.

Although the present invention has been described with reference to particular preferred embodiments, it is to be understood that various modifications in construction, arrangement and use are possible. For example, the invention disclosed herein is also applicable for use with other types of wiring and/or board constructions as well as being usable for deskewing or controlling the delay provided between other types of signals besides clock signals.

## Claims

1. A method for automatically providing de-skewed clocks for a data processing system including a plurality of circuit boards (2), each board mounting data processing circuitry chips (5), said method comprising the steps of:
applying an input clock (C) to each board (2);
on each board (2), distributing de-skewed output clocks (Cₛ) to chips (5) on the board (2) by performing automatic clock de-skewing in response to said input clock (C) using an accurate reference delay to determine the amount of de-skewing required,
wherein each circuit board (2) is of multi-layer construction comprising conductive planes (201, 203, 205, ...) separated by insulating dielectric layers (202, 204, 206, ...); and
providing said accurate reference delay for each circuit board (2) by forming a transmission line (224) along an edge portion (207a) of an inner conductive plane (207).

2. The method in accordance with claim 1, wherein said transmission line (224) is a strip transmission line having a lenghth greater than 25,4 cm (10 inches).

3. The method in accordance with claim 1, wherein said automatic clock de-skewing is performed by a clock distribution chip (5a) mounted to said board (2) and electrically coupled to said transmission line (224).

4. The method in accordance with claim 3, including locating said clock chip (5d) above said edge portion (207a), and electrically connecting said transmission line (224) and said clock chip (5a) by plated-through holes (215) formed in said board (2).

5. The method in accordance with claim 1, 2, 3 or 4, wherein said automatic clock de-skewing comprises the steps of:
producing in response to said input clock (C) a plurality of delayed signals (12a) having different delays relative to said input clock (C);
selecting one of said delayed signals (12a) for producing an output clock (Cₛ);
comparing the time relationship between a first signal derived from said output clock (Cₛ) and a second signal derived from said-input clock (C) for determining, based on the delay provided by said transmission line (224), whether the delay provided by a selected delayed signal (12a) is substantially equal to a desired predetermined delay;
automatically selecting a different delayed signal (12a) if the delay provided by a currently selected delayed signal (C′) is determined not to be substantially equal to said desired delay;
repeating the steps of comparing and automatically selecting until a currently selected delayed signal (C′) is determined to provide substantially said desired delay; and
preventing selection of a different delayed signal (12a) when the currently selected delayed signal (C′) is determined to provide a delay which is substantially equal to said desired delay.

6. The method in accordance with claim 5, wherein the step of preventing includes locking-in selection of a selected input clock (C) when it is determined to provide a delay which is substantially equal to said desired delay.

7. The method in accordance with claim 6, wherein said second signal is derived by passing said input clock (C) through said transmission line (224).

8. The method in accordance with claim 5, wherein the step of automatically selecting includes changing the count (18a) of a counter (18) in response to the step of comparing determining that the currently selected delayed signal (C′) does not provide said desired delay and selecting another delayed signal (12a) for application to said circuit dependent upon the count (18a) of said counter (18).

9. The method in accordance with claim 8, wherein said changing occurs in a manner so that each change of count (18a) increases the delay provided by the selected delayed signal (C′).

10. The method in accordance with claim 9, including the step of setting said counter (18) to an initial count prior to application of a selected input clock (C) to said circuit.

11. A data processing system including a plurality of circuit boards (2), each board mounting data processing circuitry chips (5), and a clock distribution chip (5a) which is responsive to an input clock (C) being input to the circuit board (2) and which distributes de-skewed output clocks (Cₛ) to the data processing circuitry chips (5) on said circuit board (2), and which adjusts the relative delay between an output clock (Cₛ) and said input clock (C) to a predetermined constant value, said input clock (C) being provided to an accurate reference delay means (24) to determine the required amount of de-skewing, said accurate reference delay means (24) comprising a transmission line (224),
characterized in that
each circuit board (2) is of a multi-layer construction comprising conductive planes (201, 203, 205, ...) separated by insulating dielectric layers (202, 204, 206, ...),
said transmission line (224) being formed by an edge portion (207a) of an inner conductive plane (207), the ends (224a and 224b) of said transmission line (224) being connected to the top of the circuit board (2) for receiving respective ones of the terminals of the clock distribution chip (5a).

12. The system in accordance with claim 11, wherein said transmission line (224) is a strip transmission line having a length greater than 25,4 cm (10 inches).

13. The system in accordance with claim 11, comprising an automatic clock de-skewing circuit including said accurate reference delay means (24) wherein portions of said automatic clock de-skewing circuit other than said accurate reference means (24) are provided on said clock distribution chip (5a) mounted to said board (2).

14. The system in accordance with claim 12, wherein said clock distribution chip (5a) is located above said edge portion (207a), and wherein said transmission line (224) is electrically connected to said clock distribution chip (5a) by plated-through holes (215) formed in said board (2).

15. The system in accordance with claim 13 or 14, wherein said automatic clock de-skewing circuitry comprises:
delay means (12) responsive to said input clock (C) for producing a plurality of delayed signals (12a) having different delays relative to said input clock (C);
a clock driver circuit (16) providing a plurality of output clocks (Cₛ) for feeding to other chips (5) on its respective board (2);
means for applying a selected one of said delayed signals (12a) to said clock driver circuit (16);
detecting means (24,26) including said accurate reference delay means (24) and responsive to a signal derived from an output clock (Cₛ) for determining whether a desired predetermined delay exists between said input clock (C) and said output clock (Cₛ); and
means (14,18) for automatically selecting a different delayed signal (12a) if the phase difference between said input clock (C) and said output clock is determined not to be substantially equal to said desired predetermined delay.

16. The system in accordance with claim 15 wherein said clock de-skewing circuitry includes means for preventing selection of a different delayed signal (12a) when it is determined that the currently selected delayed signal (C′) provides a delay between said input clock (C) and said output clock (Cₛ) which is substantially equal to said desired predetermined delay.

17. The system in accordance with claim 16, wherein the operation of said automatic clock de-skewing circuitry is initiated during power-on initialization, and wherein said means for preventing includes means for locking-in selection of a selected delayed signal (C′) when said detecting means (26) determines that a selected delayed signal (C′) provides a delay between said input clock (C) and said output clock (Cₛ) which is substantially equal to said desired predetermined delay.

18. The system in accordance with claim 16, wherein said detecting means (24,26) comprises means including said accurate reference delay means (24) for deriving a comparison signal having a predetermined delay relative to said input clock (C), and wherein said detecting means (24,26) also includes means (26) for comparing the time relationship between said comparison signal and a signal derived from said output clock (Cₛ) for determining whether the delay between said input clock (C) and said output clock (Cₛ) is substantially equal to said desired predetermined delay.

19. The system in accordance with claim 18, wherein said means for automatically selecting includes counting means (18), means (130) for changing the count (18a) of said counting means (18) in response to said detecting means (24,26) determining that the delay provided by a selected delayed signal (C′) is not substantially equal to said desired predetermined delay, and means (14) for selecting another delayed signal (12a) for application to said circuit dependent upon the count (18a) of said counting means (18).

20. The system in accordance with claim 19, wherein said means for automatically selecting includes multiplexor means (14) responsive to the count (18a) of said counting means (18) for selecting one of said delayed signals (12a).

21. The system in accordance with claim 20, wherein said means (14,18) for selecting another delayed signal operates such that said changing of the count (18a) of said counting means (18) causes selection of a delayed signal (12a) having a larger delay relative to said input signal (C) than that of the previously selected delayed signal (C′).

22. The system in accordance with claim 21, including means for setting said counting means (18) to an initial count.

23. The system in accordance with claim 22, wherein said means for preventing includes means for locking-in selection of a selected delayed signal (C′) when it is determined to provide a delay which is substantially equal to said desired delay.

24. The system in accordance with claim 15, wherein said delay means (12) responsive to said input clock (C) comprises a multi-tapped delay means.

25. The system in accordance with claim 24, wherein said delay means (12) comprises a plurality of serially connected gates (12b), and wherein said delayed signals (12a) are obtained from connections between said gates (12b).

## Patentansprüche

1. Verfahren zur automatischen Erzeugung begradigter Takte für ein Datenverarbeitungssystem mit einer Mehrzahl von Schaltkreisplatinen (2), wobei auf jeder Platine Datenverarbeitungs-Schaltungsbausteine (5) angeordnet sind, wobei das Verfahren folgende Schritte beinhaltet:
Anlegen eines Eingangstaktes (C) an jede Platine (2);
Verteilen begradigter Ausgangstakte (Cₛ) auf jeder Platine (2) an alle Baugruppen (5) auf der Platine (2) durch Ausführen der automatischen Taktbegradigung als Reaktion auf den Eingangstakt (C) unter Verwendung einer präzisen Referenzverzögerung zum Bestimmen des erforderlichen Betrages der Begradigung, wobei jede Schaltkreisplatine (2) eine Multi-Layer-Konstruktion ist, die leitende Ebenen (201, 203, 205, ...) umfaßt, welche durch isolierende, dielektrische Schichten (202, 204, 206, ...) getrennt sind; und
Erzeugung der präzisen Referenzverzögerung für jede Schaltkreisplatine (2) durch Bilden einer Übertragungsleitung (224) entlang eines Randabschnittes (207a) einer inneren leitenden Ebene (207) bilden.

2. Verfahren nach Anspruch 1, bei dem die Übertragungsleitung (224) eine streifenförmige Übertragungsleitung mit einer Länge von mehr als 25,4 cm (10 inches) ist.

3. Verfahren nach Anspruch 1, bei dem die automatische Taktbegradigung durch einen Taktverteilungsbaustein (5a) ausgeführt wird, der auf der Platine (2) montiert und elektrisch mit der Übertragungsleitung (224) gekoppelt ist.

4. Verfahren nach Anspruch 3, mit den Schritten des Positionierens des Taktbausteines (5d) oberhalb des Randabschnittes (207a) und des elektrischen Verbindens der Übertragungsleitung (224) und des Taktbausteines (5a) durch in der Platine (2) ausgebildete galvanisierte Durchgangslöcher (215).

5. Verfahren nach Anspruch 1, 2, 3 oder 4, bei welchem die automatische Taktbegradigung folgende Schritte umfaßt:
Erzeugen einer Mehrzahl verzögerter Signale (12a) mit unterschiedlichen Verzögerungen gegenüber dem Eingangstakt (C) als Reaktion auf den Eingangstakt (C);
Selektieren eines der verzögerten Signale (12a) zum Erzeugen eines Ausgangstaktes (Cₛ);
Vergleichen der zeitlichen Beziehung zwischen einem ersten von dem Ausgangstakt (Cₛ) abgeleiteten Signal und einem zweiten von dem Eingangstakt (C) abgeleiteten Signal, auf der Grundlage der durch die Übertragungsleitung (224) vorgegebenen Verzögerung zu bestimmen, ob die durch eine selektiertes verzögertes Signal (12a) hervorgerufene Verzögerung im wesentlichen gleich der gewünschten vorbestimmten Verzögerung ist;
automatisches Selektieren eines anderen verzögerten Signales (12a), wenn die durch ein augenblicklich selektiertes verzögertes Signal (C′) hervorgerufene Verzögerung als nicht im wesentlichen gleich der gewünschten Verzögerung bestimmt wird;
Wiederholen der Schritte des Vergleichens und des automatischen Selektierens, bis ein augenblicklich selektiertes verzögertes Signal (C′) bestimmt ist, um im wesentlichen die gewünschte Verzögerung hervorzurufen; und
Verhindern der Selektion eines anderen verzögerten Signales (12a), wenn das augenblicklich selektierte verzögerte Signal (C′) zum Verwirklichen einer Verzögerung, welche im wesentlichen gleich der gewünschten Verzögerung ist, festgelegt ist.

6. Verfahren nach Anspruch 5, bei dem der Schritt des Verhinderns eine verriegelnde Selektion eines selektierten Eingangstaktes (C) beinhaltet, wenn dieser zum Abgeben einer Verzögerung bestimmt ist, welche im wesentlichen gleich der gewünschten Verzögerung ist.

7. Verfahren nach Anspruch 6, bei dem das zweite Signal durch Führen des Eingangstaktes (C) durch die Übertragungsleitung (224) abgeleitet wird.

8. Verfahren nach Anspruch 5, bei dem der Schritt des automatischen Selektierens einen Wechsel der Zählung (18a) eines Zählers (18) als Reaktion auf den Schritt des vergleichenden Bestimmens, daß das augenblicklich selektierte verzögerte Signal (C′) nicht die gewünschte Verzögerung ergibt, und das Auswählen eines anderen verzögerten Signales (12a) zur Anwendung auf die Schaltung in Abhängigkeit vom Zählwert (18a) des Zählers (18).

9. Verfahren nach Anspruch 8, bei dem die Veränderung in der Weise auftritt, daß jede Änderung der Zählung (18a) die durch das selektierte verzögerte Signal (C′) verursachte Verzögerung erhöht.

10. Verfahren nach Anspruch 9, einschließlich des Schrittes des Setzens des Zählers (18) auf einen Anfangszählwert vor der Abgabe eine selektierten Eingangstaktes (C) auf die Schaltung.

11. Datenverarbeitungssystem mit einer Mehrzahl von Schaltkreisplatinen (2), wobei auf jeder Platine Datenverarbeitungs-Schaltungsbausteine (5) und ein Taktverteilungsbaustein (5a) montiert sind, welcher auf einen Eingangstakt (C) anspricht, der in die Schaltkreisplatine (2) eingegeben wird, und welcher begradigte Ausgangstakte (Cₛ) an die Datenverarbeitungs-Schaltungsbausteine (5) auf der Schaltkreisplatine (2) verteilt und welcher die relative Verzögerung zwischen einem Ausgangstakt (Cₛ) und dem Eingangstakt (C) auf einen vorbestimmten, konstanten Wert einstellt, wobei der Eingangstakt (C) an eine Präzisionsreferensverzögerungseinrichtung (24) abgegeben wird, um den erforderlichen Betrag der Begradigung zu bestimmen, und die Präzisionsreferensverzögerungseinrichtung (24) eine Übertragungsleitung (224) umfaßt,
dadurch gekennzeichnet, daß jede Schaltkreisplatine (2) eine Multi-Layer-Konstruktion mit durch isolierende, dielektrische Schichten (202, 204, 206, ...) getrennten leitenden Ebenen (201, 203, 205, ...) ist,
die Übertragungsleitung (224) durch einen Randabschnitt (207a) einer inneren leitenden Ebene (207) gebildet wird, die Enden (224a und 224b) der Übertragungsleitung (224) an die Oberseite der Schaltkreisplatine (2) zum Aufnehmen der entsprechenden Anschlüsse des Taktverteilungsbausteines (5a) angeschlossen sind.

12. System nach Anspruch 11, bei dem die Übertragungsleitung (224) eine streifenförmige Übertragungsleitung mit einer Länge von mehr als 25,4 cm (10 inches) ist.

13. System nach Anspruch 11, mit einer automatischen Taktbegradigungsschaltung mit der Präzisionsreferensverzögerungseinrichtung (24), bei dem andere Teile als die Präzisionsreferenzeinrichtung (24) der automatischen Taktbegradigungsschaltung in dem auf der Platine (2) montierten Taktverteilungsbaustein (5a) vorgesehen sind.

14. System nach Anspruch 12, bei dem der Taktverteilungsbaustein (5a) oberhalb des Randabschnittes (207a) angeordnet ist und bei dem die Übertragungsleitung (224) durch in der Platine (2) ausgebildete galvanisierte Durchgangslöcher (215) an den Taktverteilungsbaustein (5a) elektrisch angeschlossen ist.

15. System nach Anspruch 13 oder 14, bei dem die automatische Taktbegradigungsschaltung umfaßt:
auf den Eingangstakt (C) ansprechende Verzögerungseinrichtungen (12) zum Erzeugen einer Mehrzahl von verzögerten Signalen (12a) mit gegenüber dem Eingangstakt (C) unterschiedlichen Verzögerungen;
eine eine Mehrzahl von Ausgangstakten (Cₛ) abgebende Takttreiberschaltung (16) zum Abgeben an andere Bausteine (5) auf der entsprechenden Platine (2);
Erfassungseinrichtungen (24, 26), die die Präzisionsreferenzverzögerungseinrichtung (24) beinhalten und auf ein von einem Ausgangstakt (Cₛ) abgeleitetes Signal ansprechen, um zu bestimmen, ob eine gewünschte vorbestimmte Verzögerung zwischen dem Eingangstakt (C) und dem Ausgangstakt (Cₛ) besteht; und
Einrichtungen (14, 18) zum automatischen Selektieren eines anderen verzögerten Signales (12a), wenn die Phasendifferenz zwischen dem Eingangstakt (C) und dem Ausgangstakt als nicht im wesentlichen gleich der gewünschten vorbestimmten Verzögerung bestimmt ist.

16. System nach Anspruch 15, bei dem die Taktbegradigungsschaltung Einrichtungen zum Verhindern der Selektion eines anderen verzögerten Signales (12a) beinhaltet, wenn festgestellt ist, daß das augenblicklich selektierte verzögerte Signal (C′) eine Verzögerung zwischen dem Eingangstakt (C) und dem Ausgangstakt (Cₛ) erzeugt, welche im wesentlichen gleich der gewünschten, vorbestimmten Verzögerung ist.

17. System nach Anspruch 16, bei dem der Betrieb der automatischen Taktbegradigungsschaltung während der Einschalt-Initialisierung ausgelöst wird und bei dem die Verhinderungseinrichtung Einrichtungen zur verriegelnden Selektion eines selektierten verzögerten Signales (C′) beinhaltet, wenn die Erfassungseinrichtung (26) feststellt, daß ein selektiertes verzögertes Signal (C′) eine Verzögerung zwischen dem Eingangstakt (C) und dem Ausgangstakt (Cₛ) ergibt, welche im wesentlichen gleich der gewünschten, vorbestimmten Verzögerung ist.

18. System nach Anspruch 16, bei dem die Erfassungseinrichtung (24, 26) Einrichtungen mit der Präzisionsreferenzverzögerungseinrichtung (24) zum Ableiten eines Vergleichssignales mit einer vorbestimmten Verzögerung gegenüber dem Eingangstakt (C) beinhaltet und bei dem die Erfassungseinrichtung (24, 26) ebenfalls Einrichtungen (26) zum Vergleichen der zeitlichen Beziehung zwischen dem Vergleichssignal und dem von dem Ausgangstakt (Cₛ) abgeleiteten Signal beinhalten, um zu bestimmen, ob die Verzögerung zwischen dem Eingangstakt (C) und dem Ausgangstakt (Cₛ) im wesentlichen gleich der gewünschten, vorbestimmten Verzögerung ist.

19. System nach Anspruch 18, bei dem die Einrichtung zur automatischen Selektion eine Zähleinrichtung (18), Einrichtungen (130) zum Ändern der Zählung (18a) der Zähleinrichtung (18) als Reaktion auf die Erfassungseinrichtung (24, 26), welche bestimmt, daß die durch ein selektiertes verzögertes Signal (C′) hervorgerufene Verzögerung nicht im wesentlichen gleich der gewünschten, vorbestimmten Verzögerung ist, und Einrichtungen (14) zum Selektieren eines anderen verzögerten Signales (12a) zur Abgabe an die Schaltung in Abhängigkeit vom Zählwert (18a) der Zähleinrichtung (18) beinhaltet.

20. System nach Anspruch 19, bei dem die Einrichtung zum automatischen Selektieren eine auf den Zählwert (18a) der Zähleinrichtung (18) ansprechende Multiplexeinrichtung (14) zum Selektieren eines der verzögerten Signale (12a) beinhaltet.

21. System nach Anspruch 20, bei dem die Einrichtungen (14, 18) zum Selektieren eines anderen verzögerten Signales derart wirken, daß die Änderung des Zählwertes (18a) der Zähleinrichtung (18) die Selektion eines verzögerten Signales (12a) mit einer größeren Verzögerung gegenüber dem Eingangssignal (C) als das vorher selektierte verzögerte Signal (C′) bewirkt.

22. System nach Anspruch 21, mit Einrichtungen zum Setzen der Zähleinrichtung (18) auf einen Anfangszähwert.

23. System nach Anspruch 22, bei dem die Veränderungseinrichtung Einrichtungen zur verriegelnden Selektion eines selektierten verzögerten Signales (C′) beinhaltet, wenn festgestellt ist, daß eine Verzögerung abgegeben wird, welche im wesentlichen gleich der gewünschten Verzögerung ist.

24. System nach Anspruch 15, bei dem die auf den Eingangstakt (C) ansprechende Verzögerungseinrichtung (12) eine mehrfach angezapfte Verzögerungseinrichtung umfaßt.

25. System nach Anspruch 24, bei dem die Verzögerungseinrichtung (12) eine Mehrzahl seriell verbundener Anschlüsse (12b) umfaßt, und bei dem die verzögerten Signale (12a) von den Verbindungen zwischen den Anschlüssen (12b) erhalten werden.

## Revendications

1. Procédé pour fournir automatiquement des signaux d'horloge corrigés pour un système de traitement de données incluant une pluralité de cartes de circuits (2), chaque carte montant des puces de circuits de traitement de données (5), ledit procédé comprenant les étapes suivantes :
application d'un signal d'horloge d'entrée (C) à chaque carte (2) ;
sur chaque carte (2), répartition des signaux d'horloge de sortie corrigés (Cₛ) aux puces (5) sur la carte (2) en effectuant une correction d'horloge automatique en réponse audit signal d'horloge d'entrée (C) en utilisant un retard de référence précis pour déterminer la quantité de corrections nécessaires,
dans lequel chaque carte de circuits (2) a une structure à multicouches comprenant des plans conducteurs (201, 203, 205, ...) séparés par des couches isolantes de diélectrique (202, 204, 206, ...) ; et
fourniture dudit retard de référence précis pour chaque carte de circuits (2) en formant une ligne de transmission (224) le long d'une partie formant bord (207a) d'un plan conducteur intérieur (207).

2. Procédé selon la revendication 1, dans lequel ladite ligne de transmission (224) est une ligne de transmission triplaque ayant une longueur supérieure à 25,4 cm (10 pouces).

3. Procédé selon la revendication 1, dans lequel ladite correction automatique de signal d'horloge est effectuée par une puce de répartition de signal d'horloge (5a) montée sur ladite carte (2) et électriquement reliée à ladite ligne de transmission (224).

4. Procédé selon la revendication 3, incluant le positionnement de ladite puce de signal d'horloge (5d) au-dessus de ladite partie formant bord (207a), et reliant électriquement ladite ligne de transmission (224) et ladite puce de signal d'horloge (5a) par des trous métallisés (215) formés dans ladite carte (2).

5. Procédé selon la revendication 1, 2, 3 ou 4, dans lequel ladite correction automatique de signal d'horloge comprend les étapes suivantes :
production, en réponse audit signal d'horloge d'entrée (C), d'une pluralité de signaux retardés (12a) ayant différents retards par rapport audit signal d'horloge d'entrée (C) ;
sélection d'un desdits signaux retardés (12a) pour produire un signal d'horloge de sortie (Cₛ) ;
comparaison de la relation temporelle entre un premier signal obtenu à partir dudit signal d'horloge de sortie (Cₛ) et un second signal obtenu à partir dudit signal d'horloge d'entrée (C) pour déterminer, sur la base du retard fourni par ladite ligne de transmission (224), si le retard fourni par un signal retardé sélectionné (12a) est sensiblement égal à un retard prédéterminé souhaité ;
sélection automatique d'un signal retardé différent (12a) si le délai fourni par un signal retardé sélectionné de manière courante (C′) est déterminé comme n'étant pas sensiblement égal audit retard souhaité ;
répétition des étapes de comparaison et de sélection automatique jusqu'à ce qu'un signal retardé sélectionné de manière courante (C′) soit déterminé pour fournir sensiblement ledit retard souhaité ; et
évitement de la sélection d'un signal retardé différent (12a) lorsque le signal retardé sélectionné de manière courante (C′) est déterminé comme fournissant un retard qui est sensiblement égal audit retard souhaité.

6. Procédé selon la revendication 5, dans lequel l'étape d'évitement comprend le verrouillage de sélection d'un signal d'horloge d'entrée (C) quand il est déterminé comme fournissant un retard qui est sensiblement égal audit retard souhaité.

7. Procédé selon la revendication 6, dans lequel ledit second signal est obtenu en passant ledit signal d'horloge d'entrée (C) par l'intermédiaire de ladite ligne de transmission (224).

8. Procédé selon la revendication 5, dans lequel l'étape de sélection automatique comprend le changement du comptage (18a) d'un compteur (18) en réponse à l'étape de comparaison en déterminant que le signal retardé sélectionné de manière courante (C′) ne fournit pas ledit retard souhaité et en sélectionnant un autre signal retardé (12a) à appliquer audit circuit en fonction du comptage (18a) dudit compteur (18).

9. Procédé selon la revendication 8, dans lequel ledit changement se produit de façon que chaque changement de comptage (18a) augmente le retard fourni par le signal retardé sélectionné (C′).

10. Procédé selon la revendication 9, comprenant l'étape de fixation dudit compteur (18) à un comptage initial avant l'application d'un signal d'horloge d'entrée (C) audit circuit.

11. Système de traitement de données incluant une pluralité de cartes de circuits (2), chaque carte montant des puces de circuits de traitement de données (5), et une puce de répartition de signal d'horloge (5a) qui est sensible à un signal d'horloge d'entrée (C) en train d'être entré dans la carte de circuits (2) et qui répartit des signaux d'horloge de sortie corrigés (Cₛ) aux puces de circuits de traitement de données (5) sur ladite carte de circuits (2), et qui ajuste le retard relatif entre un signal d'horloge de sortie (Cₛ) et ledit signal d'horloge d'entrée (C) à une valeur constante prédéterminée, ledit signal d'horloge d'entrée (C) étant fourni à un moyen de retard de référence précis (24) pour déterminer la quantité de corrections nécessaires, ledit moyen de retard de référence précis (24) comprenant une ligne de transmission (224),
caractérisé en ce que :
chaque carte de circuits (2) est de structure à multicouches comprenant des plans conducteurs (201, 203, 205, ...) séparés par des couches isolantes de diélectrique (202, 204, 206, ...),
ladite ligne de transmission (224) étant formée par une partie formant bord (207a) d'un plan conducteur intérieur (207), les extrémités (224a et 224b) de ladite ligne de transmission (224) étant reliées sur le dessus de la carte de circuits (2) pour recevoir les bornes respectives des bornes de la puce de répartition de signal d'horloge (5a).

12. Système selon la revendication 11, dans lequel ladite ligne de transmission (224) est une ligne de transmission triplaque ayant une longueur supérieure à 25,4 cm (10 pouces).

13. Système selon la revendication 11, comprenant un circuit de correction automatique de signal d'horloge incluant ledit moyen de retard de référence précis (24) dans lequel des parties dudit circuit de correction automatique de signal d'horloge autres que ledit moyen de retard de référence précis (24) sont réalisées sur ladite puce de répartition de signal d'horloge (5a) montée sur ladite carte (2).

14. Système selon la revendication 12, dans lequel ladite puce de répartition de signal d'horloge (5a) est située au-dessus de ladite partie formant bord (207a), et dans lequel ladite ligne de transmission (224) est électriquement connectée à ladite puce de répartition de signal d'horloge (5a) par des trous métallisés (215) formés dans ladite carte (2).

15. Système selon la revendication 13 ou 14, dans lequel lesdits circuits de correction automatique de signal d'horloge comprennent :
un moyen de retard (12) sensible audit signal d'horloge d'entrée (C) pour produire une pluralité de signaux retardés (12a) ayant différents retards par rapport audit signal d'horloge d'entrée (C) ;
un circuit de pilotage d'horloge (16) fournissant une pluralité de signaux d'horloge de sortie (Cₛ) pour alimenter d'autres puces (5) sur sa carte respective (2);
un moyen pour appliquer un signal sélectionné desdits signaux retardés (12a) audit circuit de pilotage d'horloge (16) ;
un moyen de détection (24, 26) incluant ledit moyen de retard de référence précis (24) et sensible à un signal obtenu à partir d'un signal d'horloge de sortie (Cₛ) pour déterminer si un retard prédéterminé souhaité existe entre ledit signal d'horloge d'entrée (C) et ledit signal d'horloge de sortie (Cₛ) ; et
un moyen (14, 18) pour sélectionner, de manière automatique, un signal retardé différent (12a) si la différence de phase entre ledit signal d'horloge d'entrée (C) et ledit signal d'horloge de sortie est déterminée comme n'étant pas sensiblement égale audit retard prédéterminé souhaité.

16. Système selon la revendication 15, dans lequel lesdits circuits de correction de signal d'horloge comprennent un moyen pour empêcher la sélection d'un signal retardé différent (12a) quand il est déterminé que le signal retardé sélectionné de manière courante (C′) fournit un retard entre ledit signal d'horloge d'entrée (C) et ledit signal d'horloge de sortie (Cₛ) qui est sensiblement égal audit retard prédéterminé souhaité.

17. Système selon la revendication 16, dans lequel le fonctionnement desdits circuits de correction automatique de signal d'horloge est initié pendant l'initialisation à la mise sous tension, et dans lequel ledit moyen d'évitement comprend un moyen pour verrouiller la sélection d'un signal retardé sélectionné (C′) lorsque ledit moyen de détection (26) détermine qu'un signal retardé sélectionné (C′) fournit un retard entre ledit signal d'horloge d'entrée (C) et ledit signal d'horloge de sortie (Cₛ) qui est sensiblement égal audit retard prédéterminé souhaité.

18. Système selon la revendication 16, dans lequel ledit moyen de détection (24, 26) comprend un moyen incluant ledit moyen de retard de référence précis (24) pour obtenir un signal de comparaison ayant un retard prédéterminé par rapport audit signal d'horloge d'entrée (C), et dans lequel ledit moyen de détection (24, 26) comprend également un moyen (26) pour comparer la relation temporelle entre ledit signal de comparaison et un signal obtenu à partir dudit signal d'horloge de sortie (Cₛ) pour déterminer si le retard entre ledit signal d'horloge d'entrée (C) et ledit signal d'horloge de sortie (Cₛ) est sensiblement égal audit retard prédéterminé souhaité.

19. Système selon la revendication 18, dans lequel ledit moyen de sélection automatique comprend un moyen de comptage (18), un moyen (130) pour changer le comptage (18a) dudit moyen de comptage (18) en réponse audit moyen de détection (24, 26) en déterminant que le retard fourni par un signal retardé sélectionné (C′) n'est pas sensiblement égal audit retard prédéterminé souhaité, et un moyen (14) pour sélectionner un autre signal retardé (12a) à appliquer audit circuit en fonction du comptage (18a) dudit moyen de comptage (18).

20. Système selon la revendication 19, dans lequel ledit moyen de sélection automatique comprend un moyen formant multiplexeur (14) sensible au comptage (18a) dudit moyen de comptage (18) pour sélectionner l'un desdits signaux retardés (12a).

21. Système selon la revendication 22, dans lequel ledit moyen (14, 18) de sélection d'un autre signal retardé fonctionne de façon que ladite modification du comptage (18a) dudit moyen de comptage (18) provoque la sélection d'un signal retardé (12a) ayant un retard plus grand par rapport audit signal d'entrée (C) que celui dudit signal retardé précédemment sélectionné (C′).

22. Système selon la revendication 21, incluant un moyen pour positionner ledit moyen de comptage (18) à un comptage initial.

23. Système selon la revendication 22, dans lequel ledit moyen d'évitement comprend un moyen pour verrouiller la sélection d'un signal retardé sélectionné (C′) lorsqu'il est déterminé comme fournissant un retard qui est sensiblement égal audit retard souhaité.

24. Système selon la revendication 15, dans lequel ledit moyen de retard (12) sensible audit signal d'horloge d'entrée (C) est constitué d'un moyen de retard à prises multiples.

25. Système selon la revendication 24, dans lequel ledit moyen de retard (12) est constitué d'une pluralité de portes connectées en série (12b), et dans lequel lesdits signaux retardés (12a) sont obtenus à partir des connexions entre lesdites portes (12b).
